Europäisches Patentamt

European Patent Office

Office européen des brevets

(11) Publication number: **0 175 101 B1**

# EUROPEAN PATENT SPECIFICATION

(45) Date of publication of patent specification: **23.09.92**   (51) Int. Cl.5: **G11C 16/06**, G11C 11/409

(21) Application number: **85109507.5**

(22) Date of filing: **29.07.85**

(54) Semiconductor memory device.

(30) Priority: **17.09.84 JP 194417/84**

(43) Date of publication of application:
**26.03.86 Bulletin  86/13**

(45) Publication of the grant of the patent:
**23.09.92 Bulletin  92/39**

(84) Designated Contracting States:
**DE FR GB**

(56) References cited:
**US-A- 4 301 518**

**PATENT ABSTRACTS OF JAPAN, vol. 6, no.
82 (P-116)[960], 20th May 1982; & JP-A-57 18
086**

**PATENT ABSTRACTS OF JAPAN, vol. 7, no.
78 (P-188)[1223], 31st March 1983; & JP-A-58
6591**

**INTEL, The Semiconductor Memory Book,
John Wiley & Sons, New York, USA, 1978,
pages 130-138, J. COE: "Designing with 16K
Dynomic RAMs"**

(73) Proprietor: **KABUSHIKI KAISHA TOSHIBA
72, Horikawa-cho Saiwai-ku
Kawasaki-shi Kanagawa-ken 210(JP)**

(72) Inventor: **Miyamoto, Junichi c/o Patent Division
Kabushiki Kaisha Toshiba 1-1 Shibaura
1-chome
Minato-ku Tokyo 105(JP)**
Inventor: **Tsujimoto, Jun-ichi c/o Patent Division
Kabushiki Kaisha Toshiba 1-1 Shibaura
1-chome
Minato-ku Tokyo 105(JP)**

(74) Representative: **Lehn, Werner, Dipl.-Ing. et al
Hoffmann, Eitle & Partner Patentanwälte Arabellastrasse 4
W-8000 München 81(DE)**

EP 0 175 101 B1

## Description

The present invention relates to a semiconductor memory apparatus for use in an EPROM or EEPROM.

A semiconductor mask ROM is known from JP-A-586591. When programming such a device during manufacture, memory cells in left-hand and right-hand sections are programmed with reversed logic polarities in order to achieve correct data detection without using a level inverting circuit.

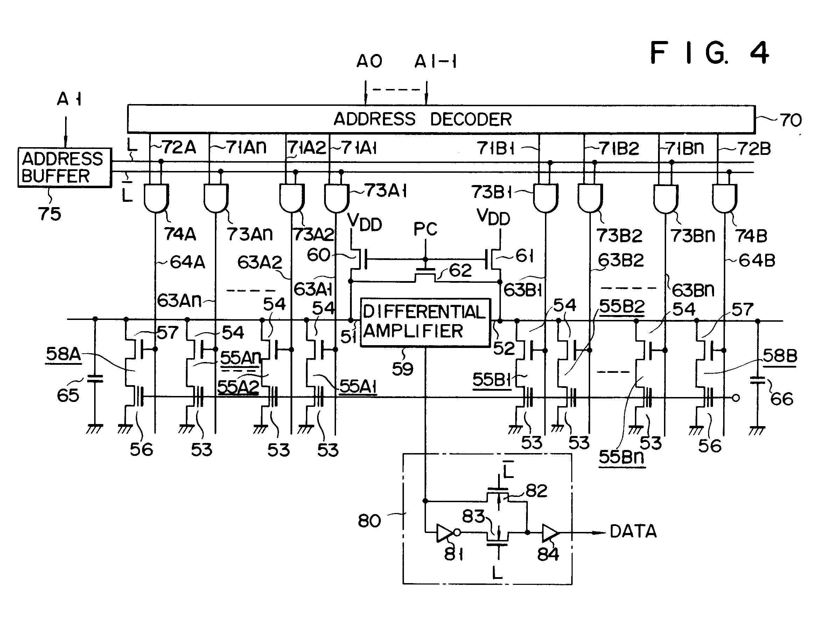

An apparatus as defined in the preamble of claim 1 is known from Intel, The Semiconductor Memory Book, John Wiley & Sons, New York, USA, 1978, pages 130-138 (Figure 4), J. COE; "Designing with 16K Dynamic RAMs".

Unlike static RAMs, semiconductor memory devices (to be referred to as memories for brevity hereinafter) such as conventional EPROMS (Electrically Programable Read-Only Memory) and conventional EEPROMSs (Electrically Erasable Programable Read-Only Memory) have one output line connected to each memory cell thereof. Its storage data ("1" level or "0" level) corresponds to an impedance level (high impedance or low impedance) of a data storage transistor for each memory cell.

In conventional memories such as EPROMs and EEPROMs, data in the memory cell is detected such that a voltage drop across the bit lines is monitored when a current flows therethrough. A memory cell of this type is described in "EEPROM USING THE FETMOS CELL", KUO et al, IEEE Journal of Solid State Circuits Vol. SC-17 No. 5, October 1982, p. 825.

According to the detection scheme described above, when impedances of the respective memory cells deviate from the prescribed value due to manufacturing process errors, the memory cells will not often be operated. In addition, the amount of the current flowing through the bit lines tends to be influenced by element characteristic variations due to manufacturing process errors, thereby decreasing an operating margin and hence resulting in inconvenience.

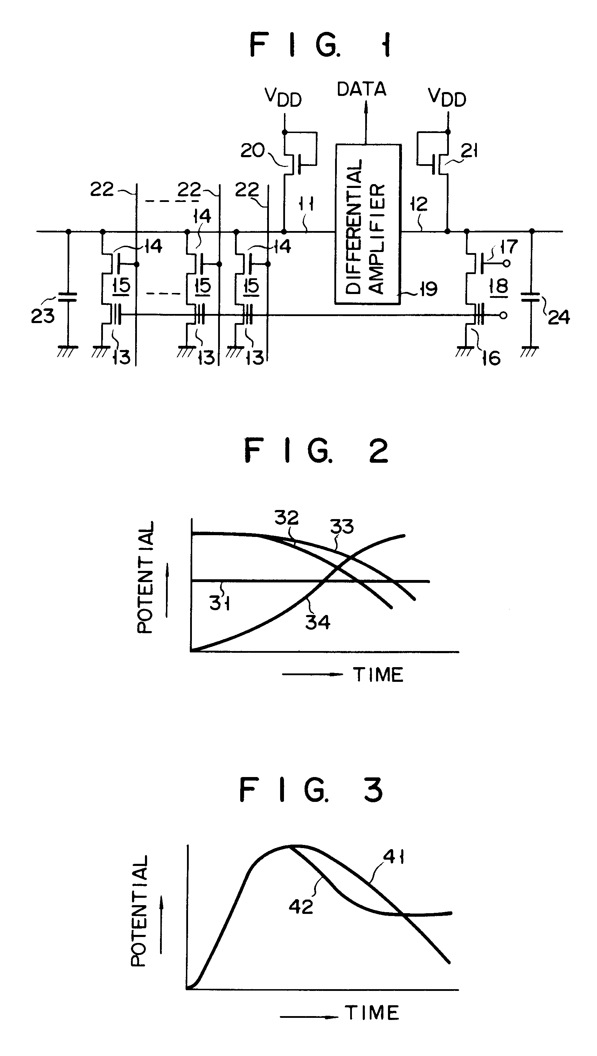

In order to solve the above problem, a conventional memory shown in Fig. 1 is proposed. According to this memory, a pair of bit lines 11 and 12 are provided, and a plurality of EEPROM memory cells 15 each comprising a data storage nonvolatile transistor 13 with a floating gate and a selection transistor 14 are connected to the bit line 11. One dummy cell 18 comprising a nonvolatile transistor 16 with a floating gate and a selection transistor 17 is connected to the bit line 12. A differential amplifier 19 is connected between the pair of bit lines 11 and 12. In addition, load transistors 20 and 21 are connected to the bit lines 11 and 12, respectively. The gate of the selection transistor 14 in each memory cell 15 is connected to a corresponding one of word lines 22. Parasitic capacitances 23 and 24 are present in the bit lines 11 and 12, respectively.

In order to read out data from a memory cell in the memory, the corresponding word line 22 is driven to select the corresponding memory cell 15. The impedance level (high impedance or low impedance) between the source and drain of the transistor 13 of the selected memory cell 15 is set at a given level in accordance with the storage data (i.e., "1" logic level or "0" logic level), so that the potential at the bit line 11 is set in accordance with this impedance level. For example, when the impedance of the transistor 13 of the selected memory cell 15 is high, the bit line 11 is charged to a power source voltage VDD through the transistor 20. However, when the impedance of the transistor 13 is low, the bit line 11 is discharged to 0 V or the ground potential. Therefore, the potential at the bit line 11 is set at VDD or 0 V (ground potential) in accordance with the impedance level of the transistor 13. Assume that the storage data is set at "0" logic level when the bit line is discharged and set at the ground potential in the following description. A conductance of the ON transistor 16 in the dummy cell 18 is selected to be smaller than that of the transistor 13 in the memory cell 15, or a conductance of the transistor 21 is selected to be smaller than that of the transistor 20 in the memory cell 15, so that the potential at the bit line 12 is set at an intermediate value of a potential amplitude of the bit line 11. In this case, a potential difference between the bit lines 11 and 12 is amplified by the differential amplifier 19, thereby detecting the storage data. It should be noted that the control gates of the transistors 13 and 16 are commonly connected, and the common junction receives one of the following potentials corresponding to the modes to be set. In the data erase mode, a high voltage, e.g., 20 V is applied to the common junction; in the data program mode, the ground voltage is applied to the common junction; and in the data read mode, a voltage, e.g., 2.5 V is applied to the common junction.

A problem in the memory shown in Fig. 1 lies in the fact that the capacitances 23 and 24 present in the bit lines 11 and 12 greatly differ from each other. More particularly, when the cells 15 and 18 are selected, a potential at the bit line 12 reaches a predetermined potential for a relatively short period of time since the capacitance 24 is small. However, the bit line 11 is connected to a number of memory cells 15, and the capacitance 23 is extremely large. For this reason, the voltage change characteristic of the bit line 11 slowly varies in accordance with variations of the impedances of the transistors 20 and 13.

Fig. 2 is a graph showing the potentials at the bit lines 11 and 12 as a function of time. Referring to Fig. 2, a line 31 represents a change in potential at the bit line 12, curves 32 and 33 represent changes in potentials at the bit line 11 when the bit line 11 is charged and the impedances of the transistors 13 are different, and a curve 34 represents a change in potential at the bit line 11 when the bit line 11 is charged through the transistor 20. As is apparent from Fig. 2, the timing at which the potential at the bit line 11 is lower than that at the bit line 12 differs from the correct timing due to the difference between the discharge rates due to the variations of the impedances of the transistors 13. The impedances of the transistors 13 with the floating gate are especially influenced by manufacturing process errors. Therefore, it is difficult to reduce the access time of this memory device.

In order to solve the above problem, another conventional memory is also proposed. According to this memory, a pulse signal is generated upon address updating. A short-circuit MOS transistor is connected between a pair of bit lines 11 and 12 and is controlled by the pulse signal. The characteristic curves of this memory which correspond to those of Fig. 2 are illustrated in Fig. 3. The bit lines 11 and 12 are short-circuited by the short-circuit MOS transistor when the address is updated, so that a potential 41 at the bit line 11 is the same as a potential 42 at the bit line 12 after the lines 11 and 12 are short-circuited. Therefore, since a parasitic capacitance 24 of the bit line 12 is so small, the potential 42 at the bit line 12 reaches a predetermined potential for a relatively short period of time. However, when the impedances of the transistor 13 in the selected memory cell 15 are small, the bit line 11 is discharged to the ground potential. However, since a parasitic capacitance 23 present in the bit line 11 is large, a voltage drop at the bit line 11 is slower than that at the bit line 12. For this reason, data cannot be detected before the potential 41 at the bit line 11 falls below the potential 42 at the bit line 12. As a result, this memory cannot provide a shortened access time.

The present invention has been made in consideration of the above situation and has as its object to provide a semiconductor memory device wherein the data read time and hence the access time can be shortened.

According to the invention there is provided a semiconductor memory apparatus for use in an EPROM or EEPROM in which stored data are erasable comprising: a first bit line connected to a plurality of memory cells and at least one dummy cell; a second bit line connected to a plurality of memory cells and at least one dummy cell; input means for writing data into said memory cells connected to said first bit line using logic of a given polarity; cell selecting means for selecting the dummy cell connected to said second bit line when one of the memory cells connected to said first bit line is to be selected and the dummy cell connected to said first bit line when one of the memory cells connected to said second bit line is to be selected; and data detecting means for amplifying a potential difference between said first and second bit lines and detecting storage data of a selected memory cell; characterized by: said input means writing data into said memory cells connected to said second bit line using logic of said given polarity; and data output means for inverting or noninverting the data detected by said data detecting means in accordance with the bit line which is connected to the memory cell selected by said cell selecting means.

This invention can be more fully understood from the following detailed description when taken in conjunction with the accompanying drawings, in which:

Fig. 1 is a circuit diagram of a conventional semiconductor memory device;

Fig. 2 is a graph showing changes in potentials at bit lines of the conventional memory device of Fig. 1 as a function of time;

Fig. 3 is a graph showing changes in potentials at bit lines of another conventional memory device;

Fig. 4 is a circuit diagram of a semiconductor memory device according to an embodiment of the present invention;

Fig. 5 is a graph showing changes in potentials in a pair of bit lines in the memory device of Fig. 4;

Fig. 6 is a circuit diagram showing an arrangement of a differential amplifier in the memory device of Fig. 4; and

Fig. 7 is a circuit diagram of a switch in a data output circuit in the memory device of Fig. 4.

A memory device according to an embodiment of the present invention will be described with reference to Figs. 4 to 7.

Fig. 4 is a circuit diagram of a semiconductor memory device (i.e., memory) according to an embodiment of the present invention. In the same manner as in the conventional memory of Fig. 1, a pair of bit lines 51 and 52 are provided. A plurality of EEPROM memory cells 55A1, 55A2,... 55An are connected to the bit line 51. Each of the EEPROM cells comprises a data storage nonvolatile transistor 53 with a floating gate and a selection transistor 54. One dummy cell 58A is connected to the bit line 51. The dummy cell 58A comprises a nonvolatile transistor 56 having a smaller conductance than that of each of the transistors 53 and a selection transistor 57. Similarly, memory cells 55B1, 55B2,... 55Bn having the same structure as the cells 55A1, 55A2,... 55An and one dummy cell 59B are connected to the bit line 52. It should be noted that the number of memory cells 55A (representing 55A1, 55A2, ... 55An) need not be the same as that of memory cells 55B (representing 55B1, 55B2,... 55Bn) and that the number of dummy cells 58A need not be the same as that of the dummy cells 58B. However, when the numbers of the memory cells 55A and the dummy cells 58A are respectively the same as those of the memory cells 55B and the dummy cells 58B, proper operation and design of the memory cells can be easily performed. A data detection differential amplifier 59 is arranged between the bit lines 51 and 52. Precharge MOS transistors 60 and 61 are connected between the bit line 51 and a power source voltage VDD and between the bit line 52 and the power source voltage VDD, respectively. A potential equalizing MOS transistor 62 is connected between the bit lines 51 and 52 and at the same time is connected in parallel with the differential amplifier 59. A precharge control signal PC is commonly supplied to the gates of the transistors 60, 61 and 62. The gates of the selection transistors 54 in the memory cells 55A1, 55A2,... 55An are connected to word lines 63A1, 63A2,... 63An, respectively. Similarly, the gates of the transistors 54 in the memory cells 55B1, 55B2,... 55Bn are connected to word lines 63B1, 63B2,... 63Bn, respectively. The gates of the selection transistors 57 in the dummy cells 58A and 58B are connected to word lines 64A and 64B, respectively. Parasitic capacitances 65 and 66 are present in the bit lines 51 and 52, respectively.

The gates of the transistors 53 and 56 are commonly connected, and a common junction thereof is set at a predetermined potential in accordance with the designated operating mode of the memory. More particularly, in the data erase mode, a high voltage, e.g., 20 V is applied to the common junction; in the data program mode, the ground voltage is applied to the common junction; and in the data read mode, a voltage, e.g., 2.5 V, is applied to the common junction. The gates of the transistors 53 and 56 may be separated from each other and different potentials may be connected to the gates of the transistors 53 and 56. In this case, in the data erase mode, a high voltage, e.g., 20 V may be applied to the gate of only the transistor 53.

Reference numeral 70 denotes an address decoder for receiving an i-bit address signal comprising bits A0 to Ai-1. The decoder 70 drives a pair of output lines, for example, 71A2 and 71B2 among output lines 71A (representing 71A1, 71A2,... 71An) and 71B (representing 71B1, 71B2,... 71Bn) in accordance with the i-bit address signal. At the same time, the decoder 70 drives output lines 72A and 72B. Each of the signals on the output lines 71A1, 71A2,... 71An is supplied to one input terminal of the corresponding one of AND gates 73A1, 73A2,... 73An. Each of the signals on the output lines 71B1, 71B2,... 71Bn is supplied to one input terminal of the corresponding one of AND gate 73B1, 73B2,... 73Bn. Each of the signals on the output lines 72A and 72B is supplied to one input terminal of the corresponding one of AND gates 74A and 74B.

Reference numeral 75 denotes an address buffer for receiving an address bit Ai one-bit higher than the address bit Ai-1 and generating signals L and $\overline{L}$ which have complementary levels in response to the address bit Ai. The signal L from the buffer 75 is commonly supplied to the AND gates 74A and 73B, and the signal $\overline{L}$ is commonly supplied to the AND gates 74B and 73A. The outputs from the AND gates 73A1, 73A2,... 73An are supplied to the word lines 63A1, 63A2,... 63An, respectively. Similarly, the outputs from the AND gates 73B1, 73B2,... 73Bn are supplied to the word lines 63B1, 63B2,... 63Bn, respectively. The outputs from the AND gates 74A and 74B are supplied to the word lines 64A and 64B, respectively.

A data output circuit 80 comprises an inverter 81, two N channel MOS transistors 82 and 83 constituting a MOS switch, and a buffer circuit 84. More particularly, the input terminal of the inverter 81 is connected to the output terminal of the differential amplifier 59. The output terminal of the inverter 81 is connected to one terminal of a current path of the transistor 83. The other terminal of this current path is connected to the input terminal of the buffer circuit 84. The gate of the transistor 82 receives the signal $\overline{L}$, and the gate of the transistor 83 receives the signal L.

The data detected by the differential amplifier 59 is supplied to the data output circuit 80. The circuit 80 inverts or does not invert the detection data of the differential amplifier 59 in accordance with the designated logic level of the signal L or $\overline{L}$. Specifically, when the signal $\overline{L}$ is at "1" logic level, the detection data from the differential amplifier 59 are supplied to the buffer circuit 84 through the transistor 82 which receives the signal $\overline{L}$ at its gate. When the signal L is at "1" logic level, the detection data are supplied to the buffer circuit 84 through a series circuit of the inverter 81 and the transistor 83 which receives the signal L at its gate. Output data from the buffer circuit 84 generated as read data is finally accessed from the memory device.

With the memory device having the arrangement described above, since the number of memory cells 55A connected to the bit line 51 is the same as that of memory cells 55B connected to the bit line 52 and the number of dummy cells 58A is the same as that of dummy cells 58B, the parasitic capacitances 65 and 66 are substantially the same. As previously described, the numbers of memory cells 55A and dummy cells 58A may be different from those of memory cells 55B and the dummy cells 58B, provided the difference would not affect the circuit operation.

The mode of operation of the memory according to the above embodiment will be described hereinafter. When address updating is detected by a means (not shown), the precharge control signal (pulse signal) PC is generated. The signal PC is supplied to the gates of the transistors 60, 61 and 62 which are turned on for a predetermined period of time (i.e., a pulse width of the precharge pulse signal). As a result, the bit lines 51 and 52 are charged to the voltage VDD and are kept at the same potential. When the predetermined period of time (i.e., falling of the signal PC) has elapsed, the transistors 60, 61 and 62 are turned off to terminate precharging and equalization of the bit lines 51 and 52. On the other hand, after the address is updated, any one pair (e.g., 71A2 and 71B2) of the output lines 71A and 71B in accordance with the logic levels of the input address bits A0 to Ai-1. At the same time, the lines 72A and 72B are driven. The outputs L and $\overline{L}$ from the address buffer 75 are set at determined levels in accordance with the logic level of the input address bit Ai. In this embodiment, the input address bit Ai is set at logic "1", the signals L and $\overline{L}$ are set at the "1" and "0" levels, respectively. Now assume that the address bit Ai is set at "1" logic level and that the output signals L and $\overline{L}$ from the buffer 75 are set at "1" and "0" the logic levels, respectively. In this case, the AND gates 73A and 74B supply the output signals from the decoder 70 to the corresponding word lines 63A and 63B. One (e.g., 63A2) of the word lines 63A which is accessed by the address signal is driven, and the memory cell 55A2 corresponding to the driven word line 63A2 is selected. Furthermore, the word line 64B is driven to select corresponding dummy cell 58B. In this manner, when the siganl $\overline{L}$ is set at "1" logic level and the signal L is set at "0" logic level, one memory cell (e.g., 55A2), accessed by the address signal, among the memory cells 55A connected to the bit line 51 is selected. At the same time, the dummy cell 58B connected to the bit line 52 is selected.

However, when the address bit Ai of "0" level is supplied to the buffer 75, the levels of the signals L and $\overline{L}$ are inverted, i.e., "0" and "1" levels, respectively. In this case, the dummy cell 58A connected to the bit line 51 is selected, and one memory cell (e.g., 55B2) accessed by the address signal and selected among the memory cells 55B connected to the bit line 52 is selected. More particularly, when the designated one of the memory cells 55A is selected in accordance with the logic levels of the output signals L and $\overline{L}$ generated from the buffer 75, the dummy cell 58B connected to the bit line 52 is selected. However, when the designated one of the memory cells 55B is selected, the dummy cell 58A connected to the bit line 51 is selected.

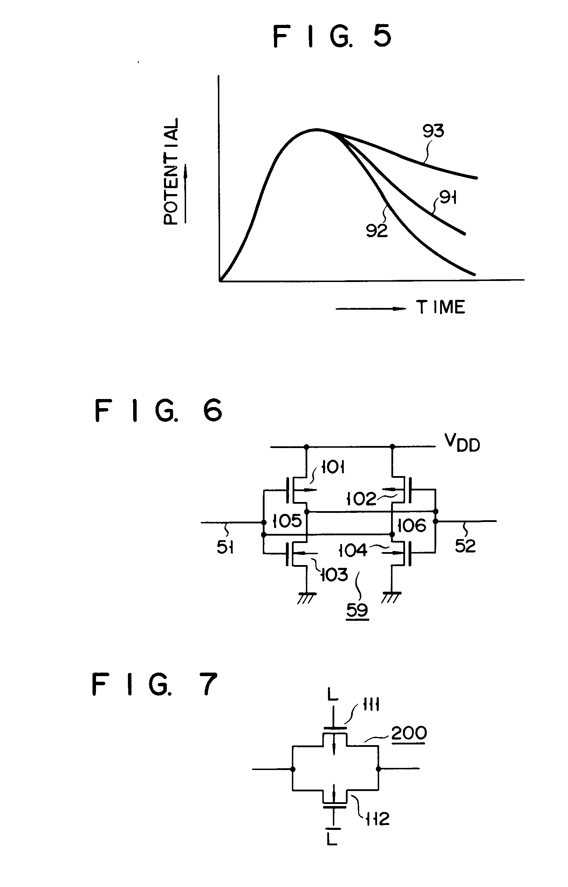

When the memory cell 55 (representing one of the memory cells 55A and 55B) and the dummy cell 58 (representing the corresponding one of the dummy cells 58A and 58B), one of the bit lines 51 and 52 which is connected to the designated memory cell 55 is kept at the precharge potential (i.e., VDD) or is discharged in accordance with the impedance level (high impedance or low impedance) of the transistor 53 of the designated memory cell. The conductance of the transistor 56 of the dummy cell 58 is smaller than that of the transistor 53 in the memory cell 55 but is larger than that of the transistor 56 for storing "1" level data. Therefore, the bit line connected to the designated dummy cell 58 is also discharged. Unlike the conventional memory device wherein the delay is caused by the difference between the parasitic capacitances of the bit lines, as shown in Fig. 3, the delay does not occur in the memory of this embodiment since the parasitic capacitances 65 and 66 present in the bit lines 51 and 52 are substantially the same. Fig. 5 is a graph showing changes in potentials at the bit lines 51 and 52 as a function of time. Referring to Fig. 5, a curve 91 represents a change in the potential of the bit line connected to the designated dummy cell, and curves 92 and 93 represent changes in potentials at the bit line connected to the designated memory cell. The curve 92 is obtained when the designated memory cell stores "0" level data; and the curve 93 is obtained when the designated memory cell stores "1" level data. In this embodiment, since the capacitances 65 and 66 are substantially the same, a delay will not occur between a change in potential at the bit line connected to the designated dummy cell and a change in potential at the bit line connected to the designated memory cell which stores the "0" level data, as shown in Fig. 5. The delay occurs only by the performance, especially an offset voltage, of the differential amplifier 59. For this reason, a potential difference corresponding to the memory cell data occurs between the bit lines 51 and 52 immediately after the equalizing is completed. When such a potential difference is detected, data detection can be performed. It should be noted that a decrease in the potential (represented by the curve 93) of the bit line connected to the designated memory cell for storing the "1" logic level occurs over time because a threshold voltage of the transistor 56 is decreased due to substrate leakage.

The delay time caused by the potential difference between the bit lines due to the parasitic capacitances can be substantially eliminated from the memory device of this embodiment. For this reason, the data detection time of the differential amplifier 59 can be shortened, and hence the data read time can be shortened, thereby performing high-speed accessing. In addition, in this embodiment, unlike the conventional memory wherein all the memory cells are connected to one of the bit lines, all the memory cells are divided into groups and each group is connected to the corresponding one of the bit lines, thereby decreasing the parasitic capacitance per bit line. This is especially advantageous in EPROMs and EEPROMs having cell transistors with a low conductance in order to shorten the data read time.

In this embodiment, the memory cells 55A and 55B are connected to the bit lines 51 and 52, respectively, so that the detection data from the differential amplifier 59 cannot be read out as the final read data. This is because the level of the detection data from the differential amplifier 59 is different in accordance with the selected bit line 51 or 52 even if the memory cells 55A and 55B store the same contents (e.g., "1" level data). In order to solve this problem, the level of the detection data from the differential amplifier 59 must be inverted in accordance with the selected bit line 51 or 52. This data inversion can be achieved by the data output circuit 80. It is assumed the data detected by the differential amplifier 59 when the memory cell 55A connected to the bit line 51 is selected has a correct level. In the circuit 80, the data passes without inversion through the n-channel MOS transistor 82 controlled by the output signal $\overline{L}$ from the buffer 75. The noninverted signal is then supplied to the buffer circuit 84. However, the detection data from the differential amplifier 59 upon selection of the memory cell 55B connected to the bit line 52 is inverted through the n-channel MOS transistor 83 controlled by the output signal L from the buffer 75 so that the detection data have a correct level. The inverted output is supplied to the buffer circuit 84. Therefore, the data having the correct logic level can be always generated from the circuit 80.

Fig. 6 is a detailed circuit diagram of the differential amplifier in the memory of the above embodiment. The differential amplifier 59 comprises a flip-flop circuit, and more particularly, a CMOS inverter 105 of a p-channel MOS transistor 101 and an n-channel MOS transistor 103, and a CMOS inverter 106 of a p-channel MOS transistor 102 and an n-channel MOS transistor 104. The sources of the transistors 101 and 102 are connected to the VDD power source potential, and the drains thereof are connected to the drains of the transistors 103 and 104, respectively. The sources of the transistors 103 and 104 are grounded. The gates of the transistors 101 and 103 are connected to each other, and the common junction constitutes the input terminal of the inverter 105. The gates of the transistors 102 and 104 are connected to each other, and the common junction constitutes the input terminal of the inverter 106. The common junction between the drains of the transistors 101 and 103 constitutes the output terminal of the inverter 105, and the common junction between the drains of the transistors 102 and 104 constitutes the output terminal of the inverter 106. The input terminals of the inverters 105 and 106 are connected to each other, and the common junction thereof is connected to the bit line 51. The output terminals of the inverters 105 and 106 are connected to each other, and the common junction thereof is connected to the bit line 52. Output data from one of the inverters 105 and 106 is generated as the detection data from the differential amplifier 59.

The present invention is not limited to the above embodiment. Various changes and modifications may be made within the scope of the invention. In the above embodiment, the EEPROM memory has memory cells 55 each comprising the nonvolatile transistor 53 and the selection transistor 54. However, the present invention can be applied to an EPROM memory wherein the selection transistor 54 is omitted and only the nonvolatile transistor 53 is provided. In the above embodiment, the switch in the data output circuit 80 comprises an n-channel MOS structure but may be replaced with a p-channel MOS structure. Furthermore, as shown in Fig. 7, a CMOS switch 200 having two transistors (i.e., a p-channel MOS transistor 111 and an n-channel MOS transistor 112) which are parallel-connected may be used.

Furthermore, the number of memory cells connected to one bit line need not be the same as that connected to the other bit line.

## Claims

1. Semiconductor memory apparatus for use in an EPROM or EEPROM in which stored data are erasable comprising:

    a first bit line (51) connected to a plurality of memory cells (55A) and at least one dummy cell (58A);

    a second bit line (52) connected to a plurality of memory cells (55B) and at least one dummy cell (58B);

    input means for writing data into said memory cells connected to said first bit line using logic of a given polarity;

    cell selecting means (73A,73B,74A,74B,75) for selecting the dummy cell connected to said second bit line when one of the memory cells connected to said first bit line is to be selected and the dummy cell connected to said first bit line when one of the memory cells connected to said second bit line is to be selected; and

data detecting means (59) for amplifying a potential difference between said first and second bit lines and detecting storage data of a selected memory cell; characterized by:

said input means writing data into said memory cells connected to said second bit line using logic of said given polarity; and

data output means (80) for inverting or noninverting the data detected by said data detecting means in accordance with the bit line which is connected to the memory cell selected by said cell selecting means.

2. Apparatus according to claim 1, characterized in that each of the memory cells comprises a nonvolatile transistor for statically storing the data.

3. Apparatus according to claim 1, characterized in that one one dummy cell is connected to each of said first and second bit lines.

4. Apparatus according to claim 1, further comprising means (62) for precharging said first and second bit lines before the data is read out from the selected memory cell.

5. Apparatus according to claim 1, characterized in that data is electrically erasable.

**Patentansprüche**

1. Halbleiterspeichervorrichtung zur Verwendung in einem EPROM oder EEPROM, in dem gespeicherte Daten löschbar sind, umfassend:

eine erste Bitleitung (51), die an eine Vielzahl von Speicherzellen (55A) und wenigstens eine Dummy-Zelle (58A) angeschlossen ist;

eine zweite Bitleitung (52), die an eine Vielzahl von Speicherzellen (55B) und wenigstens einer Dummy-Zelle (58B) angeschlossen ist;

eine Eingangseinrichtung zum Schreiben von Daten in die an die erste Bitleitung angeschlossenen Speicherzellen unter Verwendung einer Logik einer vorgegebenen Polarität;

einer Zellenauswahleinrichtung (73A, 73B, 74A, 74B, 75) zum Auswählen der von an die zweite Bitleitung angeschlossenen Dummy-Zelle, wenn eine der an die erste Bitleitung angeschlossenen Speicherzellen ausgewählt werden soll, und der an die erste Bitleitung angeschlossenen Dummy-Zelle, wenn eine der an die zweite Bitleitung angeschlossenen Speicherzellen ausgewählt werden soll; und

eine Datenerfassungseinrichtung (59) zum Verstärken einer Potentialdifferenz zwischen den ersten und zweiten Bitleitungen und zum Erfassen von Speicherdaten einer ausgewählten Speicherzelle;

dadurch **gekennzeichnet**, daß

die Eingabeeinrichtung unter Verwendung einer Logik der vorgegebenen Polarität einen Datenwert in die an die zweite Bitleitung angeschlossenen Speicherzellen schreibt; und

eine Datenabgabeeinrichtung (80) vorgesehen ist, zum Invertieren oder Nichtinvertieren der von der Datenerfassungseinrichtung erfaßten Daten entsprechend der Bitleitung, die an die von der Zellenauswähleinrichtung ausgewählten Speicherzelle angeschlossen ist.

2. Vorrichtung nach Anspruch 1, dadurch gekennzeichnet, daß jede die Speicherzellen einen nichtflüchtigen Transistor zum statischen Speichern der Datenwerte umfaßt.

3. Vorrichtung nach Anspruch 1, dadurch gekennzeichnet, daß eine Dummy-Zelle an jede der ersten und zweiten Bitleitungen angeschlossen ist.

4. Vorrichtung nach Anspruch 1, außerdem umfassend eine Einrichtung (62) zum Vorbeladen der ersten und zweiten Bitleitungen, bevor der Datenwert von der ausgewählten Speicherzelle ausgelesen wird.

5. Vorrichtung nach Anspruch 1, dadurch gekennzeichnet, daß Daten elektrisch löschbar sind.

**Revendications**

1. Dispositif de mémoire à semiconducteur destiné à une utilisation dans une EPROM ou une EEPROM dans laquelle des données stockées peuvent être effacées, comprenant :

une première ligne de bit (51) connectée à une pluralité de cellules de mémoire (55A) et à au moins une cellule fictive (58A) ;

une seconde ligne de bit (52) connectée à une pluralité de cellules de mémoire (55B) et à au moins une cellule fictive (58B) ;

un moyen d'entrée pour écrire des données dans lesdites cellules de mémoire connectées à ladite première ligne de bit en utilisant une logique d'une polarité donnée ;

un moyen de sélection de cellule (73A, 73B, 74A, 74B, 75) pour sélectionner la cellule fictive connectée à ladite seconde ligne de bit lorsque l'une des cellules de mémoire connectées à ladite première ligne de bit doit être sélectionnée et pour sélectionner la cellule fictive connectée à ladite première ligne de bit lorsque l'une des cellules de mémoire connectées à ladite seconde ligne de bit doit être sélectionnée ; et

un moyen de détection de données (59) pour amplifier une différence de potentiel entre lesdites première et seconde lignes de bit et pour détecter des données de stockage d'une cellule de mémoire sélectionnée ;

caractérisé par :

ledit moyen d'entrée qui écrit des données dans lesdites cellules de mémoire connectées à ladite seconde ligne de bit en utilisant une logique de ladite polarité donnée ; et

un moyen de sortie de données (80) pour inverser ou ne pas inverser les données détectées par ledit moyen de détection de données en fonction de la ligne de bit qui est connectée à la cellule de mémoire sélectionnée par ledit moyen de sélection de cellule.

2. Dispositif selon la revendication 1, caractérisé en ce que chacune des cellules de mémoire comprend un transistor non rémanent destiné à stocker de façon statique les données.

3. Dispositif selon la revendication 1, caractérisé en ce qu'une cellule fictive est connectée à chacune desdites première et seconde lignes de bit.

4. Dispositif selon la revendication 1, comprenant en outre un moyen (62) pour précharger lesdites première et seconde lignes de bit avant que les données ne soient extraites de la cellule de mémoire sélectionnée.

5. Dispositif selon la revendication 1, caractérisé en ce que les données peuvent être effacées électriquement.

# F I G. 1

DATA

$V_{DD}$       $V_{DD}$

20      21

DIFFERENTIAL AMPLIFIER

22    22    22

14     14     14

11       12

15    15    15     19    17

23             18    24

13    13    13     16

# F I G. 2

POTENTIAL

32   33

31

34

→ TIME

# F I G. 3

POTENTIAL

41

42

→ TIME

9

F I G. 4

# F I G. 5

# F I G. 6

# F I G. 7